# EUROPÄISCHE PATENTSCHRIFT

(11) **EP 1 687 879 B1**
(45) Veröffentlichungstag und Bekanntmachung des Hinweises auf die Patenterteilung: **10.12.2008**
(21) Anmeldenummer: 04790047.7
(22) Anmeldetag: 26.10.2004
(51) Int. Cl.: H01S 5/026, H01L 27/15

(54) **LICHTEMITTIERENDES HALBLEITERBAUELEMENT MIT EINER SCHUTZDIODE**
LIGHT-EMITTING SEMICONDUCTOR COMPONENT COMPRISING A PROTECTIVE DIODE
COMPOSANT SEMI-CONDUCTEUR ELECTROLUMINESCENT MUNI D'UNE DIODE DE PROTECTION

(30) Priorität: 28.11.2003 DE 10356283; 03.02.2004 DE 102004005269
(43) Veröffentlichungstag der Anmeldung: 09.08.2006
(73) Patentinhaber: OSRAM Opto Semiconductors GmbH, 93055 Regensburg (DE)
(72) Erfinder: ALBRECHT, Tony, 93077 Bad Abbach (DE); BRICK, Peter, 93049 Regensburg (DE); PHILIPPENS, Marc, 93049 Regensburg (DE); PLAINE, Glenn-Yves, 93047 Regensburg (DE)
(74) Vertreter: Epping, Wilhelm
(86) Internationale Anmeldenummer: PCT/DE2004/002384
(87) Internationale Veröffentlichungsnummer: WO 2005/055379

(56) Entgegenhaltungen:
- US-B1- 6 185 240
- PATENT ABSTRACTS OF JAPAN Bd. 1998, Nr. 12, 31. Oktober 1998 (1998-10-31) -& JP 10 200159 A (ROHM CO LTD), 31. Juli 1998 (1998-07-31)
- PATENT ABSTRACTS OF JAPAN Bd. 1997, Nr. 05, 30. Mai 1997 (1997-05-30) -& JP 09 027651 A (OKI ELECTRIC IND CO LTD), 28. Januar 1997 (1997-01-28)
- PATENT ABSTRACTS OF JAPAN Bd. 006, Nr. 176 (E-130), 10. September 1982 (1982-09-10) -& JP 57 093591 A (HITACHI LTD), 10. Juni 1982 (1982-06-10)
- PATENT ABSTRACTS OF JAPAN Bd. 1997, Nr. 05, 30. Mai 1997 (1997-05-30) -& JP 09 027657 A (OKI ELECTRIC IND CO LTD), 28. Januar 1997 (1997-01-28)
- PATENT ABSTRACTS OF JAPAN Bd. 2000, Nr. 14, 5. März 2001 (2001-03-05) -& JP 2000 312033 A (NICHIA CHEM IND LTD), 7. November 2000 (2000-11-07)
- PATENT ABSTRACTS OF JAPAN Bd. 008, Nr. 103 (E-244), 15. Mai 1984 (1984-05-15) -& JP 59 019389 A (FUJITSU KK), 31. Januar 1984 (1984-01-31)

## Beschreibung

Die Erfindung betrifft eine lichtemittierendes Halbleiterbauelement nach dem Oberbegriff des Patentanspruchs 1.

Die zunehmende Miniaturisierung optoelektronischer Bauelemente und spezielle Anforderungen, insbesondere hinsichtlich des Schwellstroms und der Strahlqualität, führen dazu, daß die strahlungsemittierende aktive Fläche derartiger Bauelemente oftmals verhältnismäßig klein ausgebildet wird. Andererseits ist bekannt, daß eine verhältnismäßig kleine aktive Fläche eine erhöhte Empfindlichkeit des Bauelements gegen elektrostatische Entladungen (ESD - Electro Static Discharge) bewirkt. Derartige ESD-Spannungspulse können ein optoelektronisches Bauelement in seiner Funktion beeinträchtigen oder sogar zerstören.

Aus der US 6,185 240 B1 ist eine Vertikalresonator-Laserdiode (VCSEL - Vertical Cavity Surface Emitting Laser) bekannt, die zur Erhöhung der ESD-Festigkeit eine monolithisch auf dem Halbleitersubstrat integrierte Schutzdiode enthält. Durch einen mehrstufigen Ätzprozeß und eine geeignete Führung der Kontaktmetallisierungen ist diese Schutzdiode antiparallel zum VCSEL geschaltet, und schützt den VCSEL auf diese Weise vor ESD-Spannungspulsen, die in Sperrichtung des pn-Übergangs des VCSEL auftreten.

Ein weiteres strahlungsemittierendes Halbleiterbauelement mit verbesserter ESD-Festigkeit ist aus der DE 199 45 134 A1 bekannt. Bei diesem Bauelement ist eine monolithisch integrierte Schutzdiode dadurch realisiert, daß ein Teil des pn-Übergangs mit einem Schottky-Kontakt versehen ist. Der mit dem Schottky-Kontakt versehene Teilabschnitt ist parallel zu dem lichtemittierenden Abschnitt geschaltet und weist die gleiche Durchlaßrichtung auf. Aufgrund einer steileren Strom-Spannungs-Kennlinie erfolgt der Stromfluß bei hohen Spannungen in Durchlaßrichtung bevorzugt durch den Schutzdiodenabschnitt. Dieses Bauelement ist auf diese Weise gegen ESD-Spannungspulse in Durchlaßrichtung geschützt.

In der Druckschrift JP 10 200159 A ist ein Licht emittierendes Halbleiterbauelement beschrieben, bei dem ein Licht emittierendes Bauelement und eine Schutzdiode auf einem gemeinsamen Substrat angeordnet sind. Eine n-dotierte Schicht des Licht emittierenden Bauelements und eine p-dotierte Schicht der Schutzdiode sind elektrisch miteinander verbunden. Eine p-dotierte Schicht des Licht emittierenden Bauelements und eine n-dotierte Schicht der Schutzdiode sind ebenso elektrisch miteinander verbunden.

Die Druckschrift JP 57 093591 A beschreibt einen Laserdioden-Chip mit einem pn-Übergang und einer Schutzdiode mit einem pnp- oder einem npn-Übergang, die miteinander elektrisch verbunden sind.

Aus der Druckschrift JP 09 027651 A ist ein Halbleiterlaser bekannt, der ein Laserdioden-Bauelement und ein antiparalleles Dioden-Bauelement aufweist, und so vor ESD-Spannungspulsen, die in Sperrichtung des pn-Übergangs der Laserdiode auftreten, geschützt wird.

In der Druckschrift JP 09 027657 A ist ein Halbleiterlaser beschrieben, bei dem eine Diode mit einem pn-Übergang und ein Halbleiterlaser auf einem gemeinsamen Substrat ausgebildet sind.

Der Erfindung liegt die Aufgabe zugrunde, ein lichtemittierendes Halbleiterbauelement anzugeben, das sich durch einen verbesserten Schutz gegen ESD-Spannungspulse in Sperrichtung des lichtemittierenden pn-Übergangs auszeichnet und mit verhältnismäßig geringem Aufwand herstellbar ist.

Diese Aufgabe wird durch lichtemittierende Halbleiterbauelemente mit den Merkmalen der Patentansprüche 1 oder 2 gelöst. Vorteilhafte Ausgestaltungen und Weiterbildungen der Erfindung sind Gegenstand der abhängigen Ansprüche.

Ein lichtemittierendes Halbleiterbauelement enthält gemäß der Erfindung eine monolithisch hergestellte Halbleiterschichtenfolge, wobei ein Bereich n-dotierter Halbleiterschichten und ein Bereich p-dotierter Halbleiterschichten aufeinanderfolgen, und zwischen den Bereichen ein erster pn-Übergang ausgebildet ist, wobei der erste pn-Übergang von einem isolierenden Abschnitt in einen lichtemittierenden Abschnitt und einen Schutzdiodenabschnitt unterteilt ist. Der isolierende Abschnitt isoliert den lichtemittierenden Abschnitt und den Schutzdiodenabschnitt in dem Bereich der p-dotierten Halbleiterschichten elektrisch voneinander. Im Bereich des Schutzdiodenabschnitts ist auf dem Bereich der p-dotierten Halbleiterschichten eine n-dotierte Schicht aufgebracht, die mit dem Bereich der p-dotierten Halbleiterschichten des lichtemittierenden Abschnitts elektrisch leitend verbunden ist und mit dem p-dotierten Bereich des Schutzdiodenabschnitts einen zweiten pn-Übergang ausbildet. Der Schutzdiodenabschnitt weist eine größere Fläche als der lichtemittierende Abschnitt auf.

Demgemäß sind im Schutzdiodenabschnitt ein erster pn-Übergang und ein zweiter pn-Übergang mit entgegengesetzter Polung in Reihe geschaltet. Diese in Reihe geschalteten pn-Übergänge sind wiederum mit dem pn-Übergang des lichtemittierenden Abschnitts parallel geschaltet. Bei einer in Durchflußrichtung des ersten pn-Übergangs angelegten Spannung, beispielsweise der Betriebsspannung des lichtemittierenden Bauelements, ist der zweite pn-Übergang im Schutzdiodenabschnitt in Sperrichtung gepolt. Der Stromfluß erfolgt daher im wesentlichen nur durch den lichtemittierenden Abschnitt.

Wird dagegen eine Spannung in Sperrichtung des ersten pn-Übergangs an das Halbleiterbauelement angelegt, ist der zweite pn-Übergang im Schutzdiodenabschnitt in Durchflußrichtung gepolt. Der erste pn-Übergang ist in diesem Fall sowohl im lichtemittierenden Abschnitt als auch im Schutzdiodenabschnitt in Sperrichtung gepolt. Bei einem ESD-Spannungspuls in Sperrichtung, der eine Durchbruchspannung des ersten pn-Übergangs übersteigt, erfolgt der Stromfluß bevorzugt durch den Schutzdiodenabschnitt, da dieser eine größere Fläche als der lichtemittierende Abschnitt aufweist. Die Gefahr einer Beschädigung oder Zerstörung des aufgrund seiner geringen Fläche besonders empfindlichen ersten pn-Übergangs im lichtemittierenden Abschnitt wird dadurch vorteilhaft vermindert.

Unter der Fläche des ersten pn-Übergangs im Schutzdiodenabschnitt bzw. im lichtemittierenden Abschnitt wird im Rahmen der Erfindung die in der Ebene der Grenzfläche zwischen dem p-dotierten Bereich und dem n-dotierten Bereich des ersten pn-Übergangs für einen Stromfluss zwischen elektrischen Kontakten des Bauelements zur Verfügung stehende Fläche verstanden. Bei der Ermittlung dieser Flächen sollen Flächenanteile nicht berücksichtigt werden, durch die ein Stromfluss verhindert ist, beispielsweise aufgrund von zur räumlichen Strombegrenzung in der Halbleiterschichtenfolge vorgesehenen isolierenden Bereichen.

Bevorzugt ist die Fläche des ersten pn-Übergangs im Schutzdiodenabschnitt mindestens um einen Faktor 100 größer als im lichtemittierenden Abschnitt. In diesem Fall erfolgt der Stromfluß im Fall eines ESD-Spannungspulses im wesentlichen durch den Schutzdiodenabschnitt.

Ein Vorteil des erfindungsgemäßen lichtemittierenden Halbleiterbauelements besteht darin, daß die Schichtstruktur verhältnismäßig einfach hergestellt werden kann. Beispielsweise sind keine Ätzprozesse erforderlich, die sich von der Oberfläche der Halbleiterschichtenfolge bis zur Oberfläche des Substrats erstrecken, da der lichtemittierende Abschnitt und der Schutzdiodenabschnitt nur in dem Bereich der p-dotierten Halbleiterschichten voneinander isoliert werden müssen.

Die Emissionswellenlänge des lichtemittierenden Halbleiterbauelements ist bei der Erfindung nicht auf den sichtbaren Spektralbereich beschränkt. Die Emission kann insbesondere auch im infraroten oder ultravioletten Spektralbereich erfolgen.

Die Halbleiterschichtenfolge ist beispielsweise auf einem Halbleitersubstrat aufgebracht. Es ist aber auch möglich, daß ein ursprünglich zum Aufwachsen der Halbleiterschichtenfolge verwendetes Aufwachssubstrat abgelöst ist. Zur Kontaktierung des lichtemittierenden Bauelements ist beispielsweise eine erste Kontaktmetallisierung auf einer von der Halbleiterschichtenfolge abgewandten Seite des Halbleitersubstrats und eine zweite Kontaktmetallisierung auf Teilbereichen der dem Halbleitersubstrat gegenüberliegenden Oberfläche des lichtemittierenden Abschnitts aufgebracht.

Der isolierende Abschnitt erstreckt sich zum Beispiel von der Oberseite der Halbleiterschichtenfolge bis in den Bereich der n-dotierten Schichten. Die n-dotierten Bereiche des lichtemittierenden Abschnitts und des Schutzdiodenabschnitts sind somit zumindest teilweise nicht von dem isolierenden Abschnitt unterbrochen.

Der lichtemittierende Abschnitt kann insbesondere durch eine Vertikalresonator-Laserdiode (VCSEL) gebildet sind. Der Laserresonator des VCSEL ist beispielsweise aus einer ersten Bragg-Reflektor-Schichtenfolge und einer zweiten Bragg-Reflektor-Schichtenfolge gebildet, von denen jede eine Mehrzahl von Schichtpaaren aufweist, wobei der erste pn-Übergang zwischen den beiden Bragg-Reflektoren angeordnet ist und einer der beiden Bragg-Reflektoren für die in dem pn-Übergang erzeugte Laserstrahlung teildurchlässig ist.

Bevorzugt ist in einer der beiden Bragg-Reflektor-Schichtenfolgen mindestens eine Stromapertur vorgesehen, mit der der Stromfluß durch den aktiven Bereich des lichtemittierenden Abschnitts räumlich begrenzt wird. Mit dieser Maßnahme kann insbesondere der Strahlquerschnitt eingeengt werden und die Schwellstromdichte verringert werden.

Der isolierende Abschnitt ist zum Beispiel als Graben ausgebildet, so daß der lichtemittierende Abschnitt und der Schutzdiodenabschnitt seitlich des Grabens eine mesaförmige Struktur aufweisen. Der Graben ist beispielsweise durch einen Ätzprozeß oder durch eine mechanische Mikrostrukturierung hergestellt. Die Innenseite des Grabens ist vorteilhaft mit einer isolierenden Schicht versehen. Die zweite Kontaktmetallisierung kann in diesem Fall nach der Erzeugung des Grabens aufgebracht werden und dabei der Graben mit dem Material der zweiten Kontaktmetallisierung aufgefüllt werden, ohne daß der Graben seine isolierende Wirkung verliert.

Die Erfindung wird im folgenden anhand eines Ausführungsbeispiels näher erläutert.

Es zeigen:
- Figur 1: einen schematisch dargestellten Querschnitt durch ein lichtemittierendes Halbleiterbauelement gemäß der Erfindung und
- Figur 2: ein Ersatzschaltbild des in Figur 1 dargestellten Halbleiterbauelements.

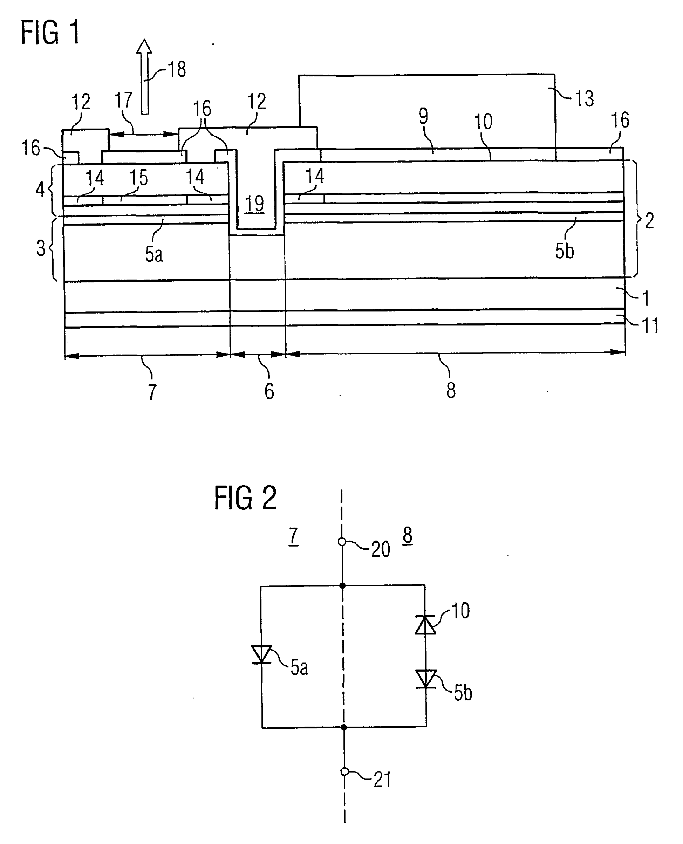

Das in Figur 1 dargestellte lichtemittierende Halbleiterbauelement ist eine Vertikalresonator-Laserdiode (VCSEL). Der VCSEL enthält ein Substrat 1, auf das eine Halbleiterschichtenfolge 2 aufgebracht ist. Die Halbleiterschichtenfolge 2 enthält einen Bereich n-dotierter Schichten 3 und einen Bereich p-dotierter Halbleiterschichten 4, zwischen denen ein erster pn-Übergang 5a,5b ausgebildet ist. Der pn-Übergang 5a,5b wird von einem isolierenden Abschnitt 6 in einen lichtemittierenden Abschnitt 7 und einen Schutzdiodenabschnitt 8 unterteilt. Die Fläche des ersten pn-Übergangs 5b im Schutzdiodenabschnitt 8 ist größer, bevorzugt um mehr als einen Faktor 100 größer, als die Fläche des ersten pn-Übergangs 5a im lichtemittierenden Abschnitt 7.

Der pn-Übergang 5a im lichtemittierenden Abschnitt 7 stellt die aktive Zone des VCSEL dar. Der Bereich n-dotierter Halbleiterschichten 3 und der Bereich p-dotierter Halbleiterschichten 4 enthalten Bragg-Reflektoren, die jeweils eine Mehrzahl reflektierender Schichtpaare (nicht dargestellt) enthalten. Die Bragg-Reflektoren bilden den Laserresonator des VCSEL. Der der Oberfläche des VCSEL zugewandte Bragg-Reflektor im Bereich der p-dotierten Halbleiterschichten 4 ist zur Auskopplung der Laserstrahlung 18 teildurchlässig ausgebildet.

Die elektrische Kontaktierung des VCSEL ist durch eine erste Kontaktmetallisierung 11 an der von der Halbleiterschichtenfolge 2 abgewandten Seite des Substrats 1 und eine zweite Kontaktmetallisierung 12 an der Oberfläche der Halbleiterschichtenfolge 2 realisiert. Die Oberfläche des lichtemittierenden Abschnitts 7 ist nur teilweise von der zweiten Kontaktmetallisierung 12 bedeckt, so daß eine Lichtaustrittsöffnung 17 verbleibt. Die Oberfläche des lichtemittierenden Abschnitts 7 ist in diesem Bereich bevorzugt mit einer isolierenden Schicht 16 versehen, welche die Oberflächen der Halbleiterschichten insbesondere vor Oxidation oder sonstigen Umwelteinflüssen schützt.

Der Stromfluß durch den lichtemittierenden Abschnitt 7 ist vorteilhaft durch eine Stromapertur 14 auf einen zentralen Bereich 15 begrenzt. Die Stromapertur 14 kann insbesondere im Bereich der p-dotierten Halbleiterschichten 4 ausgebildet sein. Beispielsweise ist in diesem Bereich 4 eine Aluminium enthaltende Halbleiterschicht, insbesondere AlAs, vorhanden, in der Teilbereiche 14 oxidiert sind. Die oxidierten Bereiche 14 wirken isolierend, so daß der Stromfluß auf einen zentralen Bereich 15 eingeschränkt wird. Eine Stromapertur 14 kann auch im Schutzdiodenabschnitt 8 vorhanden sein. Zwar ist eine Begrenzung der für den Stromfluss zur Verfügung stehenden Fläche in diesem Abschnitt nicht erwünscht, allerdings kann eine Herstellung der Stromapertur auf beiden Seiten des Grabens 19 das Herstellungsverfahren vereinfachen. In diesem Fall sollte die Fläche der Stromapertur 14 im Schutzdiodenabschnitt 8 wesentlich größer als im lichtemittierenden Abschnitt 7 sein.

Der isolierende Abschnitt 6 ist beispielsweise als ein Graben 19, der sich von der Oberfläche der Halbleiterschichten 2 bis in den Bereich der n-dotierten Halbleiterschichten 3 erstreckt, ausgebildet. Die p-dotierten Bereiche 4 des lichtemittierenden Abschnitts 7 und des Schutzdiodenabschnitts 8 werden durch den Graben 19 voneinander getrennt und elektrisch isoliert. Der Bereich n-dotierter Halbleiterschichten 3 ist dagegen zumindest nicht vollständig von dem Graben 19 unterbrochen, so daß der lichtemittierende Abschnitt 7 und der Schutzdiodenabschnitt 8 in diesem Bereich elektrisch miteinander verbunden sind. Der den isolierenden Abschnitt 6 bildende Graben 19 kann beispielsweise durch einen Ätzprozeß oder eine mechanische Bearbeitung hergestellt werden. Auf seiner Innenseite ist der Graben 19 vorteilhaft mit einer isolierenden Schicht 16 versehen. Dadurch wird sichergestellt, daß beim Aufbringen der zweiten Kontaktmetallisierung 12 kein Kurzschluß zwischen dem lichtemittierenden Abschnitt 7 und dem Schutzdiodenabschnitt 8 auftritt. Vor dem Aufbringen der isolierenden Schicht 16 können die Stromaperturen 14 durch einen Oxidationsprozeß von der Innenseite des Grabens 19 aus hergestellt werden.

Anstatt den isolierenden Abschnitt 6 als Graben 19 auszubilden, ist es alternativ ist es auch möglich, daß der isolierende Abschnitt 6 durch Implantation oder Diffusion eines Fremdmaterials in die Halbleiterschichtenfolge 2, oder durch eine Oxidation eines Teils der Halbleiterschichtenfolge 2 hergestellt ist.

Im Bereich des Schutzdiodenabschnitts 8 ist auf die Oberfläche des Bereichs der p-dotierten Halbleiterschichten 4 eine n-dotierte Halbleiterschicht 9 aufgebracht. Dazwischen ist ein zweiter pn-Übergang 10 ausgebildet. Auf die n-dotierte Halbleiterschicht 9 ist ein zur elektrischen Kontaktierung des VCSEL vorgesehenes Bondpad 13 aufgebracht, das mit der zweiten Kontaktmetallisierung 12 elektrisch leitend verbunden ist. Im Bereich des Schutzdiodenabschnitts 8 sind der erste pn-Übergang 5b und der zweite pn-Übergang 10 in Reihe geschaltet. Durch die erste Kontaktmetallisierung 11 und die zweite Kontaktmetallisierung 12 beziehungsweise das Bondpad 13 sind der lichtemittierende Abschnitt 7 und der Schutzdiodenabschnitt 8 parallel geschaltet.

Dies wird durch das in Figur 2 dargestellte Ersatzschaltbild verdeutlicht. Die linke Seite des Ersatzschaltbilds entspricht dem lichtemittierenden Abschnitt 7 und die rechte Seite dem Schutzdiodenabschnitt 8. Der lichtemittierende Abschnitt 7 enthält nur den ersten pn-Übergang 5a. Dieser ist auch im Schutzdiodenabschnitt 8 enthalten, wobei aber der zweite pn-Übergang 10 in entgegengesetzter Polung mit diesem in Reihe geschaltet ist.

Beim Betrieb des VCSEL liegt die Betriebsspannung an den Kontakten 20, 21 in Durchflußrichtung des ersten pn-Übergangs 5a,5b an. Der zweite pn-Übergang 10 im Schutzdiodenabschnitt 8 ist in diesem Fall in Sperrichtung gepolt, so daß der Stromfluß im wesentlichen nur durch den lichtemittierenden Abschnitt 7 erfolgt. Bei einem ESD-Spannungspuls in Sperrichtung des ersten pn-Übergangs 5a,5b ist der zweite pn-Übergang 10 dagegen in Durchlaßrichtung gepolt, so daß der elektrische Widerstand des Schutzdiodenabschnitts 8 im wesentlichen vom Widerstand des ersten pn-Übergangs 5b bestimmt wird. Da die Fläche des ersten pn-Übergangs 5b im Schutzdiodenabschnitt 8 größer ist als die Fläche des ersten pn-Übergangs 5a im lichtemittierenden Abschnitt 7, fließt ein durch den Spannungspuls bewirkter Sperrstrom im wesentlichen durch den ersten pn-Übergang 5b im Schutzdiodenabschnitt 8. Der zur Strahlungserzeugung vorgesehene erste pn-Übergang 5a im lichtemittierenden Abschnitt 7 wird dadurch vor einer Schädigung durch den Spannungspuls geschützt. Die Schutzwirkung ist um so besser, je größer das Verhältnis der Fläche des ersten pn-Übergangs (5a,5b) im Schutzdiodenabschnitt 8 zur Fläche im lichtemittierenden Abschnitt 7 ist.

Der erste pn-Übergang 5b im Bereich des Schutzdiodenabschnitts 8 kann in einer weiteren Ausführungsform der Erfindung kurzgeschlossen sein. Dies ist zum Beispiel durch eine elektrisch leitende Schicht (in Fig. 1 nicht dargestellt) möglich, die auf eine dem Schutzdiodenabschnitt 8 zugewandte Seitenflanke der Halbleiterschichtenfolge 2 aufgebracht ist und den Bereich n-dotierter Halbleiterschichten 3 und den Bereich p-dotierter Halbleiterschichten elektrisch miteinander verbindet. Im Fall eines ESD-Spannungspulses in Sperrrichtung fließt der Strom bei dieser Ausführung nicht durch den ersten pn-Übergang 5b, sondern durch die elektrisch leitende Schicht und den zweiten pn-Übergang 10. Folglich ist es bei dieser Ausführung auch nicht erforderlich, dass die Fläche des ersten pn-Übergangs 5b im Schutzdiodenabschnitt 8 größer ist als die Fläche des ersten pn-Übergangs 5a im lichtemittierenden Abschnitt 7.

Im Rahmen der Erfindung ist es möglich, daß die angegebenen Leitungstypen p und n der Halbleiterschichten jeweils gegeneinander vertauscht sind. In diesem Fall sind alle in der Beschreibung genannten Leitungstypen p und n als gegeneinander ausgetauscht anzusehen.

Die Erläuterung der Erfindung anhand des Ausführungsbeispiels ist selbstverständlich nicht als Einschränkung auf dieses zu verstehen.

## Patentansprüche

1. Lichtemittierendes Halbleiterbauelement mit einer monolithisch hergestellten Halbleiterschichtenfolge (2), wobei ein Bereich n-dotierter Halbleiterschichten (3) und ein Bereich p-dotierter Halbleiterschichten (4) aufeinanderfolgen, und zwischen den Bereichen (3, 4) ein erster pn-Übergang (5a,5b) ausgebildet ist, wobei
- der erste pn-Übergang (5a,5b) von einem isolierenden Abschnitt (6) in einen lichtemittierenden Abschnitt (7) und einen Schutzdiodenabschnitt (8) unterteilt ist,
- der isolierende Abschnitt (6) den lichtemittierenden Abschnitt (7) und den Schutzdiodenabschnitt (8) in dem Bereich der p-dotierten Halbleiterschichten (4) elektrisch voneinander isoliert, und
- der Bereich der p-dotierten Halbleiterschichten (4) im Schutzdiodenabschnitt (8) auf der von dem ersten pn-Übergang (5b) abgewandten Seite mit einer n-dotierten Halbleiterschicht (9) versehen ist, die mit dem Bereich p-dotierter Halbleiterschichten (4) im Schutzdiodenabschnitt (8) einen zweiten pn-Übergang (10) ausbildet und mit dem Bereich p-dotierter Halbleiterschichten (4) im lichtemittierenden Abschnitt (7) elektrisch leitend verbunden ist,
**dadurch gekennzeichnet, dass**
- der erste pn-Übergang (5a,5b) im Schutzdiodenabschnitt (8) eine größere Fläche als im lichtemittierenden Abschnitt (7) aufweist.

2. Lichtemittierendes Halbleiterbauelement mit einer monolithisch hergestellten Halbleiterschichtenfolge (2), wobei ein Bereich p-dotierter Halbleiterschichten (3) und ein Bereich n-dotierter Halbleiterschichten (4) aufeinanderfolgen, und zwischen den Bereichen (3, 4) ein erster pn-Übergang (5a,5b) ausgebildet ist, wobei
- der erste pn-Übergang (5a,5b) von einem isolierenden Abschnitt (6) in einen lichtemittierenden Abschnitt (7) und einen Schutzdiodenabschnitt (8) unterteilt ist,
- der isolierende Abschnitt (6) den lichtemittierenden Abschnitt (7) und den Schutzdiodenabschnitt (8) in dem Bereich der n-dotierten Halbleiterschichten (4) elektrisch voneinander isoliert, und
- der Bereich der n-dotierten Halbleiterschichten (4) im Schutzdiodenabschnitt (8) auf der von dem ersten pn-Übergang (5b) abgewandten Seite mit einer p-dotierten Halbleiterschicht (9) versehen ist, die mit dem Bereich n-dotierter Halbleiterschichten (4) im Schutzdiodenabschnitt (8) einen zweiten pn-Übergang (10) ausbildet und mit dem Bereich n-dotierter Halbleiterschichten (4) im lichtemittierenden Abschnitt (7) elektrisch leitend verbunden ist,
**dadurch gekennzeichnet, dass**
- der erste pn-Übergang (5a,5b) im Schutzdiodenabschnitt (8) eine größere Fläche als im lichtemittierenden Abschnitt (7) aufweist.

3. Lichtemittierendes Halbleiterbauelement nach Anspruch 1,
**dadurch gekennzeichnet, daß**
der Bereich n-dotierter Halbleiterschichten (3) zumindest teilweise nicht von dem isolierenden Abschnitt (6) unterbrochen ist.

4. Lichtemittierendes Halbleiterbauelement nach Anspruch 2,
**dadurch gekennzeichnet, daß**
der Bereich p-dotierter Halbleiterschichten (3) zumindest teilweise nicht von dem isolierenden Abschnitt (6) unterbrochen ist.

5. Lichtemittierendes Halbleiterbauelement nach einem der Ansprüche 1 oder 3,
**dadurch gekennzeichnet, daß**
sich der isolierende Abschnitt (6) von einer einem Halbleitersubstrat (1), auf das die Halbleiterschichtenfolge aufgebracht ist, gegenüberliegenden Oberfläche der Halbleiterschichtenfolge (2) bis in den Bereich der n-dotierten Schichten (3) erstreckt.

6. Lichtemittierendes Halbleiterbauelement nach einem der Ansprüche 2 oder 4,
**dadurch gekennzeichnet, daß**
sich der isolierende Abschnitt (6) von einer einem Halbleitersubstrat (1) auf das die Halbleiterschichtenfolge aufgebracht ist, gegenüberliegenden Oberfläche der Halbleiterschichtenfolge (2) bis in den Bereich der p-dotierten Schichten (3) erstreckt.

7. Lichtemittierendes Halbleiterbauelement nach einem der vorhergehenden Ansprüche,
**dadurch gekennzeichnet, daß**
die Fläche des ersten pn-Übergangs (5a,5b) im Schutzdiodenabschnitt (8) um mindestens einen Faktor 100 größer ist als im lichtemittierenden Abschnitt (7).

8. Lichtemittierendes Halbleiterbauelement nach einem der vorhergehenden Ansprüche,
**dadurch gekennzeichnet, daß**
die Halbleiterschichtenfolge (2) auf ein Halbleitersubstrat (1) aufgebracht ist.

9. Lichtemittierendes Halbleiterbauelement nach Anspruch 8,
**dadurch gekennzeichnet, daß**
eine erste Kontaktmetallisierung (11) auf einer von der Halbleiterschichtenfolge (2) abgewandten Seite des Halbleitersubstrats (1) und eine zweite Kontaktmetallisierung (12) auf Teilbereichen einer dem Halbleitersubstrat (1) gegenüberliegenden Oberfläche der Halbleiterschichtenfolge (2) aufgebracht ist.

10. Lichtemittierendes Halbleiterbauelement nach einem der vorhergehenden Ansprüche,
**dadurch gekennzeichnet, daß**
der lichtemittierende Abschnitt (7) durch eine Vertikalresonator-Laserdiode (VCSEL) gebildet ist.

11. Lichtemittierendes Halbleiterbauelement nach Anspruch 10, **dadurch gekennzeichnet, daß** der
der erste pn-Übergang (5a,5b) zwischen einer ersten Bragg-Reflektor-Schichtenfolge und einer zweiten Bragg-Reflektor-Schichtenfolge, von denen jede eine Mehrzahl von Schichtpaaren aufweist, angeordnet ist, und die beiden Bragg-Reflektor-Schichtenfolgen einen Laser-Resonator bilden, wobei eine der beiden Bragg-Reflektor-Schichtenfolgen für die in dem pn-Übergang (5a) erzeugte Laserstrahlung (18) teildurchlässig ist.

12. Lichtemittierendes Halbleiterbauelement nach Anspruch 11,
**dadurch gekennzeichnet, daß**
in einer der beiden Bragg-Reflektor-Schichtenfolgen mindestens eine Stromapertur (14) zur räumlichen Begrenzung eines im Betrieb der Vertikalresonator-Laserdiode durch den ersten pn-Übergang (5a) im lichtemittierenden Abschnitt (7) fließenden Betriebsstroms vorgesehen ist.

13. Lichtemittierendes Halbleiterbauelement nach einem der Ansprüche 9 und 10 bis 12 unter Rückbezug auf Anspruch 9,
**dadurch gekennzeichnet, daß**
die zweite Kontaktmetallisierung (12) die Oberfläche des lichtemittierenden Abschnitts derart teilweise bedeckt, daß ein unbedeckter Bereich als Lichtaustrittsöffnung (17) verbleibt.

14. Lichtemittierendes Halbleiterbauelement nach einem der vorhergehenden Ansprüche,
**dadurch gekennzeichnet, daß**
der isolierende Abschnitt (6) als Graben (19) ausgebildet ist.

15. Lichtemittierendes Halbleiterbauelement nach Anspruch 14,
**dadurch gekennzeichnet, daß**
der lichtemittierende Abschnitt (7) und der Schutzdiodenabschnitt (8) seitlich des Grabens (19) eine mesaförmige Struktur aufweisen.

16. Lichtemittierendes Halbleiterbauelement nach Anspruch 14 oder 15,
**dadurch gekennzeichnet, daß**
der Graben (19) durch Flächen begrenzt wird, die mit einer isolierenden Schicht (16) versehen sind.

17. Lichtemittierendes Halbleiterbauelement nach Anspruch 16,
**dadurch gekennzeichnet, daß**
der Graben (19) mit einem Material aufgefüllt ist, aus dem die zweite Kontaktmetallisierung (12) ausgebildet ist.

18. Lichtemittierendes Halbleiterbauelement nach einem der Ansprüche 1 bis 13,
**dadurch gekennzeichnet, daß**
der isolierende Abschnitt (6) durch einen Implantations-, Diffusions- oder Oxidationsprozess ausgebildet ist.

## Claims

1. Light-emitting semiconductor component comprising a monolithically produced sequence of semiconductor layers (2), wherein an area of n-doped semiconductor layers (3) and an area of p-doped semiconductor layers (4) follow one another and a first pn junction (5a, 5b) is formed between the areas (3, 4), wherein
- the first pn junction (5a, 5b) is subdivided into a light-emitting section (7) and a protective-diode section (8) by an insulating section (6),
- the insulating section (6) electrically insulates the light-emitting section (7) and the protective-diode section (8) from one another in the area of the p-doped semiconductor layers (4), and
- the area of the p-doped semiconductor layers (4) is provided in the protective-diode section (8) on the side facing away from the first pn junction (5b) with an n-doped semiconductor layer (9) which forms a second pn junction (10) with the area of p-doped semiconductor layers (4) in the protective-diode section (8) and is electrically conductively connected to the area of p-doped semiconductor layers (4) in the light-emitting section (7),
**characterized in that**
- the first pn junction (5a, 5b) has a larger area in the protective-diode section (8) than in the light-emitting section (7).

2. Light-emitting semiconductor component comprising a monolithically produced sequence of semiconductor layers (2), wherein an area of p-doped semiconductor layers (3) and an area of n-doped semiconductor layers (4) follow one another and a first pn junction (5a, 5b) is formed between the areas (3, 4), wherein
- the first pn junction (5a, 5b) is subdivided into a light-emitting section (7) and a protective-diode section (8) by an insulating section (6),
- the insulating section (6) electrically insulates the light-emitting section (7) and the protective-diode section (8) from one another in the area of the n-doped semiconductor layers (4), and
- the area of the n-doped semiconductor layers (4) is provided in the protective-diode section (8) on the side facing away from the first pn junction (5b) with a p-doped semiconductor layer (9) which forms a second pn junction (10) with the area of n-doped semiconductor layers (4) in the protective-diode section (8) and is electrically conductively connected to the area of n-doped semiconductor layers (4) in the light-emitting section (7),
**characterized in that**
- the first pn junction (5a, 5b) has a larger area in the protective-diode section (8) than in the light-emitting section (7).

3. Light-emitting semiconductor component according to claim 1, **characterized in that** the area of n-doped semiconductor layers (3) is not interrupted by the insulating section (6) at least in parts.

4. Light-emitting semiconductor component according to claim 2, **characterized in that** the area of p-doped semiconductor layers (3) is not interrupted by the insulating section (6) at least in parts.

5. Light-emitting semiconductor component according to one of claims 1 or 3, **characterized in that** the insulating section (6) extends from a surface of the sequence of semiconductor layers (2) opposite to a semiconductor substrate (1), onto which the sequence of semiconductor layers is applied, into the area of n-doped layers (3).

6. Light-emitting semiconductor component according to one of claims 2 or 4, **characterized in that** the insulating section (6) extends from a surface of the sequence of semiconductor layers (2) opposite to a semiconductor substrate (1), onto which the sequence of semiconductor layers is applied, into the area of p-doped layers (3).

7. Light-emitting semiconductor component according to one of the preceding claims, **characterized in that** the area of the first pn junction (5a, 5b) is larger in the protective-diode section (8) than in the light-emitting section (7) by at least a factor of 100.

8. Light-emitting semiconductor component according to one of the preceding claims, **characterized in that** the sequence of semiconductor layers (2) is applied to a semiconductor substrate (1).

9. Light-emitting semiconductor component according to claim 8, **characterized in that** a first contact metallization (11) is applied to a side of the semiconductor substrate (1) facing away from the sequence of semiconductor layers (2) and a second contact metallization (12) is applied to part-areas of a surface of the sequence of semiconductor layers (2) opposite to the semiconductor substrate (1).

10. Light-emitting semiconductor component according to one of the preceding claims, **characterized in that** the light-emitting section (7) is formed by a vertical cavity surface emitting laser (VCSEL).

11. Light-emitting semiconductor component according to claim 10, **characterized in that** the first pn junction (5a, 5b) is arranged between a first sequence of Bragg reflector layers and a second sequence of Bragg reflector layers, each of which has a multiplicity of layer pairs, and the two sequences of Bragg reflector layers form a laser resonator, one of the two sequences of Bragg reflector layers being semitransparent for the laser radiation (18) generated in the pn junction (5a).

12. Light-emitting semiconductor component according to claim 11, **characterized in that** in one of the two sequences of Bragg reflector layers, at least one current aperture (14) is provided for spatially limiting an operating current flowing through the first pn junction (5a) in the light-emitting section (7) during the operation of the vertical cavity surface emitting laser.

13. Light-emitting semiconductor component according to one of claims 9 and 10 to 12, with reference to claim 9, **characterized in that** the second contact metallization (12) partially covers the surface of the light-emitting section in such a manner that an uncovered area remains as light exit opening (17).

14. Light-emitting semiconductor component according to one of the preceding claims, **characterized in that** the insulating section (6) is constructed as trench (19).

15. Light-emitting semiconductor component according to claim 14, **characterized in that** the light-emitting section (7) and the protective-diode section (8) have a mesa-shaped structure on the side of the trench (19).

16. Light-emitting semiconductor component according to claim 14 or 15, **characterized in that** the trench (19) is bounded by areas which are provided with an insulating layer (16).

17. Light-emitting semiconductor component according to claim 16, **characterized in that** the trench (19) is filled with a material from which the second contact metallization (12) is formed.

18. Light-emitting semiconductor component according to one of claims 1 to 13, **characterized in that** the insulating section (6) is formed by an implantation, diffusion or oxidation process.

## Revendications

1. Composant semiconducteur électroluminescent comprenant une séquence de couches semiconductrices (2) fabriquée de manière monolithique, une zone de couches semiconductrices à dopage N (3) et une zone de couches semiconductrices à dopage P (4) se succédant, et une première transition PN (5a, 5b) étant formée entre les zones (3, 4),
- la première transition PN (5a, 5b) étant divisée par une portion isolante (6) en une portion électroluminescente (7) et une portion diode de protection (8),
- la portion isolante (6) isolant électriquement l'une de l'autre la portion électroluminescente (7) et la portion diode de protection (8) dans la zone des couches semiconductrices à dopage P (4) et
- la zone des couches semiconductrices à dopage P (4) étant munie dans la portion diode de protection (8), sur le côté à l'opposé de la première transition PN (5b), d'une couche semiconductrice à dopage N (9) qui, avec la zone de couches semiconductrices à dopage P (4) dans la portion diode de protection (8), forme une deuxième transition PN (10) et est reliée électriquement avec la zone de couches semiconductrices à dopage P (4) dans la portion électroluminescente (7),
**caractérisé en ce que**
- la première transition PN (5a, 5b) présente dans la portion diode de protection (8) une surface plus grande que dans la portion électroluminescente (7).

2. Composant semiconducteur électroluminescent comprenant une séquence de couches semiconductrices (2) fabriquée de manière monolithique, une zone de couches semiconductrices à dopage P (3) et une zone de couches semiconductrices à dopage N (4) se succédant, et une première transition PN (5a, 5b) étant formée entre les zones (3, 4),
- la première transition PN (5a, 5b) étant divisée par une portion isolante (6) en une portion électroluminescente (7) et une portion diode de protection (8),
- la portion isolante (6) isolant électriquement l'une de l'autre la portion électroluminescente (7) et la portion diode de protection (8) dans la zone des couches semiconductrices à dopage N (4) et
- la zone des couches semiconductrices à dopage N (4) étant munie dans la portion diode de protection (8), sur le côté à l'opposé de la première transition PN (5b), d'une couche semiconductrice à dopage P (9) qui, avec la zone de couches semiconductrices à dopage N (4) dans la portion diode de protection (8), forme une deuxième transition PN (10) et est reliée électriquement avec la zone de couches semiconductrices à dopage N (4) dans la portion électroluminescente (7),
**caractérisé en ce que**
- la première transition PN (5a, 5b) présente dans la portion diode de protection (8) une surface plus grande que dans la portion électroluminescente (7).

3. Composant semiconducteur électroluminescent selon la revendication 1, **caractérisé en ce que** la zone de couches semiconductrices à dopage N (3) est au moins partiellement non interrompue par la portion isolante (6).

4. Composant semiconducteur électroluminescent selon la revendication 2, **caractérisé en ce que** la zone de couches semiconductrices à dopage P (3) est au moins partiellement non interrompue par la portion isolante (6).

5. Composant semiconducteur électroluminescent selon l'une des revendications 1 ou 3, **caractérisé en ce que** la portion isolante (6) s'étend de la surface de la séquence de couches semiconductrices à l'opposé d'un substrat semiconducteur (1), sur lequel est appliquée la séquence de couches semiconductrices, jusque dans la zone des couches à dopage N (3).

6. Composant semiconducteur électroluminescent selon l'une des revendications 2 ou 4, **caractérisé en ce que** la portion isolante (6) s'étend de la surface de la séquence de couches semiconductrices à l'opposé d'un substrat semiconducteur (1), sur lequel est appliquée la séquence de couches semiconductrices, jusque dans la zone des couches à dopage P (3).

7. Composant semiconducteur électroluminescent selon l'une des revendications précédentes, **caractérisé en ce que** la surface de la première transition PN (5a, 5b) dans la portion diode de protection (8) est plus grande d'au moins un facteur 100 que dans la portion électroluminescente (7).

8. Composant semiconducteur électroluminescent selon l'une des revendications précédentes, **caractérisé en ce que** la séquence de couches semiconductrices (2) est appliquée sur un substrat semiconducteur (1).

9. Composant semiconducteur électroluminescent selon la revendication 8, **caractérisé en ce qu'**une première métallisation de contact (11) est appliquée sur un côté du substrat semiconducteur (1) à l'opposé de la séquence de couches semiconductrices (2) et une deuxième métallisation de contact (12) est appliquée sur des zones partielles d'une surface de la séquence de couches semiconductrices (2) à l'opposé du substrat semiconducteur (1).

10. Composant semiconducteur électroluminescent selon l'une des revendications précédentes, **caractérisé en ce que** la portion électroluminescente (7) est formée par une diode laser à résonateur vertical (VCSEL).

11. Composant semiconducteur électroluminescent selon la revendication 10, **caractérisé en ce que** la première transition PN (5a, 5b) est disposée entre une première séquence de couches de réflecteur de Bragg et une deuxième séquence de couches de réflecteur de Bragg dont chacune présente une pluralité de paires de couches et les deux séquences de couches de réflecteur de Bragg forment un résonateur laser, l'une des deux séquences de couches de réflecteur de Bragg étant partiellement transparente pour le rayonnement laser (18) généré dans la transition PN (5a).

12. Composant semiconducteur électroluminescent selon la revendication 11, **caractérisé en ce qu'**au moins une ouverture de courant (14) destinée à la délimitation dans l'espace du courant de service qui circule à travers la première transition PN (5a) dans la portion électroluminescente (7) lors du fonctionnement de la diode laser à résonateur vertical est prévue dans l'une des deux séquences de couches de réflecteur de Bragg.

13. Composant semiconducteur électroluminescent selon l'une des revendications 9 et 10 à 12, en référence à la revendication 9, **caractérisé en ce que** la deuxième métallisation de contact (12) recouvre partiellement la surface de la portion électroluminescente de telle sorte qu'il reste une zone non recouverte faisant office d'orifice de sortie de la lumière (17).

14. Composant semiconducteur électroluminescent selon l'une des revendications précédentes, **caractérisé en ce que** la portion isolante (6) est réalisée sous la forme d'un fossé (19).

15. Composant semiconducteur électroluminescent selon la revendication 14, **caractérisé en ce que** la portion électroluminescente (7) et la portion diode de protection (8) présentent une structure en forme de ruban à côté du fossé (19).

16. Composant semiconducteur électroluminescent selon la revendication 14 ou 15, **caractérisé en ce que** le fossé (19) est délimité par des surfaces qui sont dotées d'une couche isolante (16).

17. Composant semiconducteur électroluminescent selon la revendication 16, **caractérisé en ce que** le fossé (19) est rempli d'un matériau à partir duquel est réalisée la deuxième métallisation de contact (12).

18. Composant semiconducteur électroluminescent selon l'une des revendications 1 à 13, **caractérisé en ce que** la portion isolante (6) est réalisée par un processus d'implantation, de diffusion ou d'oxydation.
